Europäisches Patentamt

European Patent Office

Office européen des brevets

(11) Veröffentlichungsnummer: **0 477 709 A2**

# EUROPÄISCHE PATENTANMELDUNG

(21) Anmeldenummer: **91115663.6**

(51) Int. Cl.⁵: **H05K 9/00**

(22) Anmeldetag: **16.09.91**

(30) Priorität: **27.09.90 DE 9013586 U**

(43) Veröffentlichungstag der Anmeldung:
**01.04.92 Patentblatt 92/14**

(84) Benannte Vertragsstaaten:
**AT CH DE ES FR GB IT LI**

(71) Anmelder: **SIEMENS AKTIENGESELLSCHAFT**
**Wittelsbacherplatz 2**

**W-8000 München 2(DE)**

(72) Erfinder: **Wäger, Johann, Dipl.-Ing. FH**
**Birkensteige 6**
**W-8535 Emskirchen(DE)**
Erfinder: **Weinmann, Helmut, Dipl.-Ing. FH**
**Am Baumgarten 2**
**W-8501 Pyrbaum-Seligenporten(DE)**

(54) **Schallgedämmtes Schirmungsmodul zum Aufbau von gegen elektromagnetische Strahlung abgeschirmten Kabinen, Räumen, Hallen und Gebäuden bzw. von Auskleidungen derselben.**

(57) Das Schirmungsmodul (SM1,SM2,SM3) dient zum modularen Aufbau von Kabinen, Räumen, Hallen bzw. von bevorzugt inneren Auskleidungen und Abdeckungen für Räume, Hallen oder Gebäude, und zur Abschirmung derselben gegen den Einfall bzw. die Abstrahlung von elektromagnetischer Strahlung. Es besteht aus einem bevorzugt wannenförmigen Schirmblech (SB1,SB2 bzw.SB3). Auf der Innenseite (IS) des Schirmbleches ist mindestens eine Schalldämmplatte (SP) direkt hohlraumfrei insbesondere durch Verklebung angebracht. Die Sichtinnenseite (SS, IS) der Schalldämmplatten (SP) kann durch eine bevorzugt zumindest teilweise luftschalldurchlässige Dekorabdeckung (DA) abgedeckt sein. Zum Verschluß der Kontaktbereiche (KB1,KB2) zwischen mehreren Schirmungsmodulen sind Abdeckmittel vorgesehen, insbesondere Abdeckleisten (AL) und Abdeckkanäle (AK). Die Kontaktbereiche können auch durch auf den Innenseiten der Schalldämmplatten (SP) der Schirmungsmodulen überlappend angebrachten, zusätzlichen Schalldämmplatten (SPZ1 bzw. SPZ2) abgedeckt werden.

FIG 1

Die Erfindung betrifft ein Schirmungsmodul zum modularen Aufbau von insbesondere freitragenden Kabinen, Räumen oder Hallen bzw. von bevorzugt inneren Auskleidungen, Abdeckungen oder Abtrennungen für Räume, Hallen oder Gebäude, welches zur Abschirmung gegen den Einfall bzw. die Abstrahlung von elektromagnetischer Strahlung dient.

Elektromagnetisch abgeschirmte, freitragende bzw. gemauerte Kabinen, Räume, Hallen oder Gebäude, bzw. hierfür vorsehbare innere und äußere Auskleidungen werden häufig in Modultechnik aufgebaut. Hierzu werden z.B. zur Bildung von großflächigen Wand-, Decken-, Boden- und Abtrennelementen einzelne Schirmungsmodule elektromagnetisch leitend und hochfrequenzdicht, segmentartig miteinander verbunden. Die einzelnen Schirmungsmodule enthalten dabei im wesentlichen ein Schirmblech, welches bevorzugt aus Stahl-, verzinktem Stahl-, Aluminium- oder Kupferblech besteht. Zur elektromagnetisch abgeschirmten Verbindung von aneinanderliegenden Schirmungsmodulen werden die zugehörigen Schirmbleche entweder verschweißt oder z.B. mit Hilfe von Rahmenkonstruktionen und hochfrequenzdichten Schaubverbindungen leitend miteinander verbunden. Mit Hilfe einer derartigen modularen Aufbautechnik können zur Abschirmung gegen den Einfall bzw. die Abstrahlung von elektromagnetischer Strahlung dienende Flächen mit nahezu beliebiger Größe aufgebaut werden.

Derartige Flächen können bevorzugt als Wände, Decken und Böden für elektromagnetisch abgeschirmte Kabinen, Räumen, Hallen oder Gebäude dienen. Diese können dabei möglichst ohne Zuhilfenahme weiterer Teile freitragend direkt aus den zusammengefügten Schirmungsmodulen aufgebaut werden. Hiermit können auf besonders einfache und schnelle Weise z.B. transportable Kabinen bzw. einfache Räume und kleinere Hallen aufgebaut werden. Modular aus Schirmungsmodulen aufgebaute Flächen können aber auch zur inneren Auskleidung von gemauerten Kabinen, Räumen und Hallen, bzw. zur äußeren Verkleidung von Gebäuden verwendet werden. So werden z.B. die Innenflächen von Räumen bzw. Hallen, welche z.B. zur Prüfung von Transformatoren bzw. zur Aufnahme von Geräten für die Untersuchung des menschlichen Körpers nach dem Prinzip der elektromagnetischen Resonanz dienen, vollständig mit segmentartig zusammengefügten Schirmungsmodulen ausgekleidet. Da derartige Geräte Quellen von abgehender elektromagnetischer Störstrahlung sind, werden somit derartige Räume gegen die Abstrahlung von elektromagnetischer Strahlung gesichert. Schließlich können auch ganze Gebäude durch Verkleidung von deren Fassaden mit entsprechenden Schirmungsmodulen, z.B. bei Rechenzentren oder Bürogebäuden, insbesondere gegen den Einfall von äußerer elektromagnetischer Strahlung abgeschirmt werden.

Die Schirmbleche derartiger Schirmungsmodule sind in der Regel großflächig und dünnwandig. Sie bilden somit insbesondere bei deren Verwendung als Raum- bzw. Hallenauskleidungen nicht gedämpfte Schallreflexionsflächen. Zudem reagieren großflächige und dünne Bleche relativ sensibel bereits auf geringfügige Luftdruckschwankungen im Inneren der Kabine bzw. des Raumes. Die von stoßartigen Luftdruckerhöhungen bzw. -absenkungen z.B. beim Öffnen und Schließen von Türen verursachten Aus- bzw. Einbeulungen der Schirmbleche rufen unter Umständen erhebliche Lärmgeräusche hervor. Aus diesen Gründen müssen bei Schirmungsmodulen häufig Maßnahmen zur Schalldämmung vorgesehen werden.

So können die Schirmblechinnenseiten der Schirmungsmodule bei Bedarf z.B. nachträglich mit sogenannten Lochblechkassetten abgehängt werden. Diese enthalten gelochte Blechwandungen und sind mit Lärmdämmaterial gefüllt. Die einzelnen Lochblechkassetten werden mit Hilfe spezieller Klemmechanismen, z.B. mittels Klemmfedern, im Innenbereich des jeweiligen Schirmungsmodules gehalten. Die Abhängung von Schirmungsmodulen mit Lochblechkassetten hat zum einen den Nachteil, daß zum Aufbau der Gesamtanordnung zwei separate Arbeitsgänge notwendig sind. So müssen zunächst die zur magnetischen Abschirmung dienenden Schirmungsmodule zusammengefügt und z.B. in das Innere einer Kabine bzw. eines Raumes eingepaßt werden. Anschließend müssen in einem zweiten Arbeitsgang die Lochblechkassetten angebracht werden, wobei in der Regel wiederum Anpassungen an die jeweiligen Räumlichkeiten notwendig sind. Die Abhängung von Schirmungsmodulen mit Lochblechkassetten hat den weiteren Nachteil, daß zwischen beiden Elementen ein nicht entdröhnter Hohlraum entsteht. Aus diesem Grund ist die mit Hilfe von Lochblechkassetten erreichbare Lärmdämmung insbesondere gegenüber benachbarten Räumen relativ gering. Zudem können die oben beschriebenen, und von plötzlichen Luftdruckunterschieden hervorgerufenen Spannungsgeräusche beim Aus- und Einbeulen von großflächenen und dünnwandigen Schirmblechen in den einzelnen Schirmungsmodule nicht vermieden werden.

Schließlich kann zur Schalldämmung auf die Innenseiten der Schirmungsmodule, meist unter Verwendung einer entsprechenden Unterkonstruktion, auch eine völlständig separate Lärmdämminnenverkleidung nachträglich aufgebracht werden. Deren Gestaltung unterliegt zwar keinen Beschränkungen, ist aber sehr aufwendig. Zum einen muß die Unterkonstruktion zur Halterung der Lämdämminnenverkleidung an die Schirmungsbleche angebracht werden. Dies ist aufgrund des hohen Material- und Montageaufwandes relativ kostenintensiv. Zudem trägt eine derartige Unterkonstruktion mit aufgesetzter Lärmdämmverkleidung stark auf, so daß ein nicht unerheblicher Bestandteil des im Inneren z.B. von Kabinen reativ knappen Raumes für die Schirmungsmodule mit aufgesetzter Unterkonstruktion und Lärmdämminnenverkleidung verbraucht wird.

Demgegenüber liegt der Erfindung die Aufgabe zugrunde, modular zusammenfügbare Schirmungsmodule für Kabinen, Räume, Hallen oder Gebäude anzugeben, bei denen einen Schalldämmung auf möglichst einfache und dennoch wirksame Weise möglich ist.

Die Aufgabe wird gelöst mit dem im Anspruch 1 angegebenen Schirmungsmodul. Vorteilhafte Ausführungsformen der Erfindung sind in den Unteransprüchen angegeben.

Die Erfindung wird desweiteren anhand der in den nachfolgend kurz angeführten Figuren dargestellten, bevorzugten Ausführungsbeispielen näher erläutert. Dabei zeigt:

FIG 1    beispielhaft drei gemäß der Erfindung aufgebaute Schirmungsmodule, welche unter Verwendung von hochfrequenzdichten Schraubverbindungen miteinander verbunden sind, und deren Kontaktbereiche beispielhaft mit flächenbündigen Abdeckleisten verschlossen sind,

FIG 2    die Schirmungsmodule von FIG 1, wobei die Kontaktbereiche zwischen den einzelnen Modulen mit aufgesetzten Abdeckkanälen verschlossen sind,

FIG 3    die Schirmungsmodule von FIG 2, wobei die Abdeckkanäle zusätzlich mit Schalldämmstreifen belegt sind, und

FIG 4    eine weitere, vorteilhafte Ausführungsform der Erfindung, bei der auf der Innenseite der Schirmungsmodule zusätzliche, die Kontaktbereiche überlappend abdeckende Schalldämmplatten aufgebracht sind.

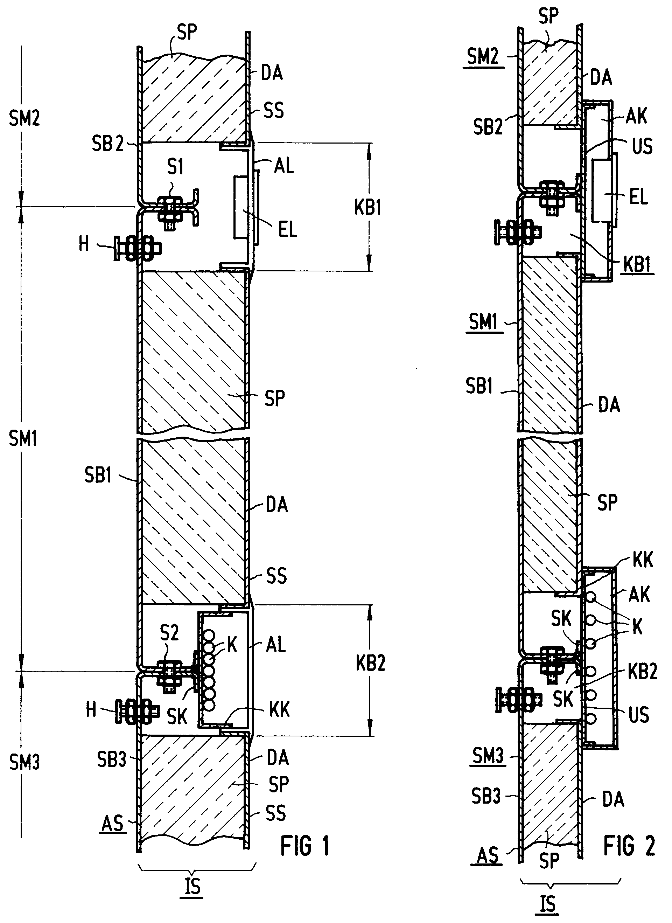

In FIG 1 sind beispielhaft drei erfindungsgemäß aufgebaute, selbsttragende Schirmungsmodule SM1, SM2, SM3 dargestellt, welche mechanisch fest und hochfrequenzdicht miteinander verbunden sind. Jedes Schirmungsmodul besteht erfindungsgemäß aus einem wannenförmig abgekanteten Schirmblech SB1, SB2 bzw. SB3 ohne zusätzliche Rahmenkonstruktion. Auf der Innenseite IS einer jeden Schirmblechwanne ist mindestens eine insbesondere aus komprimierter Mineralfaser bestehende, selbsttragende Schalldämmplatte SP direkt aufgebracht. Diese ist auf die Innenseite IS des jeweiligen Schirmbleches SB1, SB2 bzw. SB3 möglichst hohlraumfrei aufgeklebt. Dabei können die zu verklebenden Flächen entweder vollständig mit Kleber versehen sein, bzw. es können vereinzelte Klebepunkte vorgesehen sein, welche bevorzugt gleichmäßig über die Gesamtfläche verteilt sind.

Das erfindungsgemäße Schirmungsmodul hat den besonderen Vorteil, daß aufgrund der unmittelbaren, möglichst hohlraumfreien Auflage der mindestens einen selbsttragenden Schalldämmplatte auf der Innenseite des jeweiligen Schirmbleches eine besonders gute Schalldämmung auf besonders einfache Weise erreicht werden kann. Da die Schalldämmplatte aufgrund der hohen Kompression des zu ihrem Aufbau verwendeten Materials freitragend, d.h. starr und unelastisch ist, wirkt die Schalldämmplatte besonders vorteilhaft zugleich als eine zusätzliche Versteifung der großflächigen, dünnwandigen Schirmbleche. Eine derartige Versteifung hat den einen Vorteil, daß die Schirmungsmodule ohne jegliche Rahmenkonstruktionen ausgeführt werden können, d.h. lediglich aus einem wannenförmigen, bevorzugt dünnwandigen Schirmblech bestehen. Desweiteren werden Verspannungsgeräusche aufgrund von möglichen luftdruckstoßbedingten Ein- und Ausbeulungen des Schirmbleches aufgrund des erfindungsgemäßen "Verbundbaukörpers" aus wannenförmigem Schirmblech mit eingeklebter, selbsttragender Schalldämmplatte nahezu vollständig vermieden. Das erfindungsgemäße Schirmungsmodul ist somit aufgrund der hohlraumfrei direkt auf der Innenseite des jeweiligen Schirmbleches aufgeklebten Schalldämmplatte optimal "entdröhnt". Die selbsttragende Schalldämmplatte hat somit die Dreifachfunktion der akkustischen Dämmung angrenzender Raumbereiche, und der akkustischen Entdröhnung und mechanischen Stabilisierung des Schirmbleches.

Zudem sind die erfindungsgemäßen Schirmungsmodule bereits vor der Montage kostengünstig vorzufertigen. Unter deren Verwendung ist es vorteilhaft möglich, die elektromagnetische Abschirmung und akustische Dämmung von Räumen, Kabinen, Hallen oder Gebäuden mit einem einzigen Montagearbeitsgang zu erreichen. Natürlich ist es auch möglich, Schirmbleche und Schalldämmplatte erst baustellenseitig entgültig miteinander zu verbinden. Zudem wird die Hochfrequenz- und Schallabdichtung und die großflächige mechanische Stabilisierung bei geringtsmöglichem Raumverlust und mit einem minimalen Materialaufwand erreicht, da Schirmblech und Schalldämmplatte eines jeden Schirmungsmodules möglichst hohlraumfrei miteinander verbunden sind. Da diese Verbindung durch Verklebung erreicht wird, hat dies den weiteren Vorteil, daß zur Halterung der Schalldämmplatte ansich keine weiteren mechanischen Maßnahmen notwendig sind, welche die Abschirmwirkung des Schirmbleches gegenüber elektromagnetischer Strahlung möglicherweise beeinträchtigen könnten. So müssen keine, auf das Schirmblech aufgesetzte bzw. dieses durchdringende Schweiß-, Niet- oder Schraubverbindungen zur Halterung der Schalldämmplatte vorgesehen werden. Durch die Klebeverbindung bleibt die innere Struktur des Schirmbleches und der Schirmungsmodule völlig unangetastet, so daß hiervon keine, die elektromagnetische Abschirmwirkung beeinträchtigenden Einflüsse ausgehen können.

Zusätzlich zur Klebeverbindung können insbesondere aus Sicherheitsgründen bei Bedarf dennoch zusätzliche Schraub- und/oder Nietverbindungen u.U. in Verbindung mit zusätzlichen Klemmitteln zur Halterung der Schalldämmplatten vorhanden sein. Dies ist insbesondere dann vorteilhaft, wenn das Schirmungsmodul z.B. als Deckenelement verwendet wird und ein versehentliches Ablösen der Schalldämmplatte unter allen Umständen verhindert werden muß. Derartige Schraub- und/oder Nietverbindungen werden dabei ohne Beeinträchtigung der Schirmbleche bevorzugt an den umgebördelten Stoßkanten SK der Schirmbleche angebracht.

Gemäß einer weiteren, in der FIG 1 bereits dargestellten Ausführungsform der Erfindung ist die Sichtinnenseite SS der Schalldämmplatte SP eines jeden Schirmungsmodules SM1, SM2, SM3 zusätzlich mit einer bevorzugt zumindest teilweise luftschalldurchlässigen Dekorabdeckung DA belegt. Im Beispiel der FIG 1 ist dabei davon ausgegangen, daß sich links der Schirmbleche SB1, SB2, SB3 die Außenseite AS der Schirmungsmodule befindet. Diese kann frei sichtbar und zugänglich sein, z.B. wenn das erfindungsgemäße Schirmungsmodul zur Außenverkleidung von Gebäuden verwendet wird. Wird es dagegen zur Innenverkleidung von Kabinen, Räumen oder Hallen verwendet, so ist die Außenseite AS meist dem die Kabine, den Raum oder die Halle umgebenden Mauerwerk zugewandt. Zur Befestigung der einzelnen Schirmungsmodule an diesem Mauerwerk dienen die in FIG 1 beispielhaft dargestellten Haltemittel H. In diesem Fall sind die Seiten SS auf der Innenseite IS eines jeden Schirmungsmodules aus dem Inneren der ausgekleideten Kabinen bzw. des Raumes oder der Halle direkt sichtbar. Es ist somit bei dieser Anwendung vorteilhaft, die Sichtinnenseiten SS der Schalldämmplatten SP erfindungsgemäß mit einer zusätzlichen, bevorzugt zumindest teilweise luftschalldurchlässigen Dekorabdeckung DA zu versehen.

Bevorzugt besteht die Dekorabdeckung DA aus einem ebenen Lochblech bzw. gemäß der Darstellung von FIG 1 aus einer an den Kanten abgekanteten und somit teilweise um die Ecken der dazugehörigen Schalldämmplatte SP herumgezogenen Lochblech. Ein derartiges Lochblech hat den Vorteil, daß es zumindest teilweise luftschalldurchlässig ist. Der auf die Innenseite IS der Schirmungsmodule auftreffende Schall hat somit die Möglichkeit, in die Schalldämmplatte einzudringen, so daß nur ein Teil davon reflektiert wird. Bei einer weiteren Ausführung der Erfindung bilden die Schalldämmplatte SP und die Dekorabdeckung DA einen Verbundbaukörper. Hierbei sind die Schalldämmplatte und die bevorzugt aus einem Lochblech, einer gelochten Kunststoffplatte, einer Vließ-, Gewebe- oder Filzabdeckung oder einem andersartigen Material bestehende Dekorabdeckung bereits herstellungsseitig untrennbar miteinander verbunden. Dies hat beim Aufbau der erfindungsgemäßen schallgedämmten Schirmungsmodule den besonderen Vorteil, daß in einem einzigen Arbeitsgang die bereits über eine Dekorabdeckung verfügende Schalldämmplatte hohlraumfrei direkt auf die Innenseite des Schirmbleches bevorzugt aufgeklebt wird. Das erfindungsgemäße Schirmungsmodul wird somit seinerseits zu einen Kompaktbauelement, welches bei gleichzeitiger Bereitstellung einer optisch angenehmen und hygienischen Dekorabdeckung (Rieselschutz) auf der Innenseite sowohl elektromagnetisch abschirmend als auch schalldämmend ist.

Im Beispiel der FIG 1 sind drei erfindungsgemäß aufgebaute Schirmungsmodule SM1, SM2 und SM3 nebeneinanderliegend dargestellt. Deren bevorzugt wannenförmige Schirmbleche SB1, SB2 und SB3 sind dabei direkt an den abgekanteten Endstücken beispielhaft über zwei hochfrequenzdichte Schraubverbindungen S1 und S2 miteinander mechanisch fest und hochfrequenzdicht verbunden. So liegt die Schraubverbindung S1 beispielhaft im sogenannten Kontaktbereich KB1 zwischen den Schirmungsmodulen SM1 und SM2. Entsprechend liegt die Schraubverbindung S2 im Kontaktbereich KB2 zwischen den Schirmungsmodulen SM1 und SM3. Für den Fall, daß alle drei der dargestellten Schirmungsmodule separat vorgefertigt und erst nachträglich bauseitig z.B. über die hochfrequenzdichten Schraubverbindungen S1, S2 miteinander verbunden werden, ist es vorteilhaft, wenn die Kontaktbereiche KB1 und KB2 zu Montagezwecken direkt zugänglich sind. In diesem Fall sollte die Schalldämmplatte SP die jeweilige Schirmblechwanne nicht vollständig ausfüllen, sondern deren Rand zur Bildung von Kontaktbereichen freilassen. Hierdurch ist es möglich, daß bauseitig die Haltemittel H zur Fixierung der Schirmungsmodule auf Wandoberflächen und z.B. die hochfrequenzdichten Schraubverbindungen S1 und S2 zur elektromagnetisch leitenden Kontaktierung der einzelnen Schirmungsmodule ohne Schwierigkeiten montiert werden können. In diesem Fall verbleiben die bevorzugt schlitzförmigen Kontaktbereiche KB1 bzw. KB2 zwischen den Schirmungsmodulen SM1, SM2 bzw. SM1, SM3. Gemäß einer weiteren Ausführung der Erfindung sind zu deren Verschluß leistenförmige Abdeckmittel vorhanden, wobei die Abdeckmittel entweder flächenbündig auf den Sichtinnenseiten der Schalldämmplatten der benachbarten Schirmungsmodule aufliegen oder kanalförmig auf diese aufgesetzt sind. Es ist u.U. auch möglich, daß eine über die darunterliegende Schalldämmplatte überstehende Dekorabdeckung als Verschluß der Kontaktbereiche dient.

Im Beispiel der FIG 1 sind die Kontaktbereiche KB1 und KB2 beispielhaft mit je einer Abdeckleiste AL als Abdeckmittel verschlossen. Die Abdeckleisten liegen dabei möglichst wenig hervorstehend, flächenbündig auf der Sichtinnenseite SS der Schalldämmplatten SP bzw. der darauf befindlichen Dekorabdeckungen DA auf. Gemäß einer weiteren, in FIG 1 ebenfalls dargestellten Ausführungsform der Erfindung dienen diese Abdeckmittel als Träger für Einbauelemente. So ist beispielsweise in der Abdeckleiste AL für den Kontaktbereich KB1 ein Schalter bzw. eine Steckdose EL eingelassen. Desweiteren trägt die Abdeckleiste AL auf dem Kontaktbereich KB2 beispielsweise einen Kabelkanal KK mit einer Vielzahl von innenliegenden Kabeln K.

Die Abdeckleiste AL und der Kabelkanal KK liegen dabei bevorzugt auf der umgebördelten Stößkante SK der bevorzugt wannenförmigen Schirmbleche SB1 und SB3 auf. Die Ausbildung eines nicht von den Schalldämmplatten ausgefüllten Kontaktbereiches an der Stoßkante aneinanderliegenden Schirmungsmodule und der Verschluß des Kontaktbereiches mit Abdeckmitteln hat den besonderen Vorteil, daß Verkabelungen und elektrische Installationen im Inneren z.B. von Wandelementen, welche aus einer Vielzahl von miteinander verbundenen, erfindungsgemäßen Schirmungsmodulen bestehen, auf besonders einfache Weise und ohne jeglichen Eingriff in die Schirmungsmodule verlegt werden können.

Werden die Abdeckmittel bzw. darunter befindliche Kabelkanäle KK nicht nur geklemmt, sonder unter Zuhilfenahme der oben genannten, zusätzlichen Schraub- und/oder Nietverbindungen z.B. an den ungebördelten Stoßkanten SK fixiert, so können die Abdeckmittel selbst die Aufgabe der zusätzlichen Fixierung der Schalldämmplatte insbesondere aus Sicherheitsgründen übernehmen.

Bei dem in FIG 2 dargestellten Beispiel sind die Abdeckmittel als Abdeckkanäle AK ausgebildet, welche auf die Innenseiten IS der Schalldämmplatten SP bzw. darauf befindliche Dekorabdeckungen DA der nebeneinander angeordneten Schirmungsmodule SM1, SM2 bzw. SM1, SM3 aufgelegt sind. Auch hier können die Abdeckkanäle AK als Träger für Einbauelemente dienen, wie z.B. für Schalter bzw. Steckdosen EL oder Kabelkanäle KK. Die in FIG 2 dargestellte Ausführungsform mit den aufgesetzten Abdeckkanälen zum Verschluß der Kontaktbereiche KB1 und KB2 wird bevorzugt dann verwendet, wenn die Schalldämmplatte SP auf der Innenseite IS des Schirmbleches des jeweiligen Schirmungsmodules nur eine geringe Stärke aufweist. Dies ist in bestimmten Anwendungen der Fall, wenn nur geringere Anforderungen an die Güte der Schalldämmung der erfindungsgemäßen Schirmungsmodule gestellt werden müssen. So weisen die Schalldämmplatten SP in FIG 2 im Vergleich z.B. der FIG 1 eine wesentlich geringere Stärke auf. Diese entsprichtgerade der Höhe der abgekanteten Ränder der wannenförmig ausgebildeten Schirmbleche im jeweiligen Kontaktbereich. So liegt in FIG 2 der den Kontaktbereich KB2 verschließende Abdeckkanal AK beispielhaft sowohl auf den umgebördelten Stoßkanten SK der beiden Schirmbleche SB1 und SB3, als auch auf den Dekorabdeckungen DA der Schalldämmplatten in diesen Schirmblechen auf.

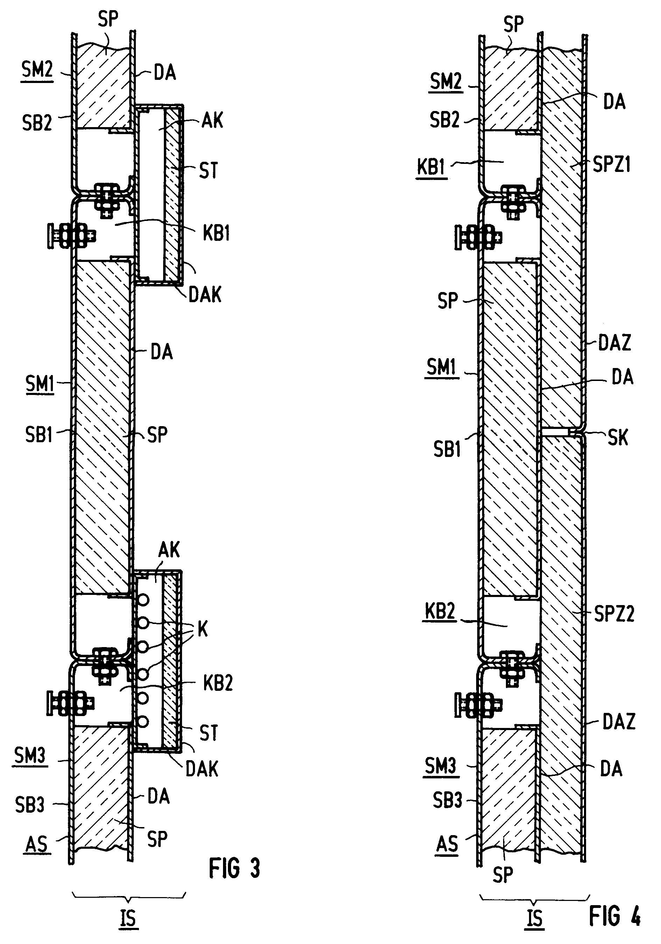

Bei dem in der FIG 3 dargestellten Ausführungsbeispiel sind die als Abdeckmittel für die Kontaktbereiche dienenden Abdeckkanäle AK zusätzlich auf der der Innenseite IS der Schirmungsmodule zugewandten Fläche mit Schalldämmstreifen ST abgedeckt.

Gemäß einer weiteren Ausführungsform können die Abdeckmittel oder die Schalldämmstreifen ebenfalls mit einer zusätzlichen Dekorabdeckung versehen sein. Im Beispiel der FIG 3 sind die Schalldämmstreifen ST auf den Abdeckkanälen AK über den Kontaktbereich KB1, KB2 mit einer zusätzlichen, bevorzugt zumindest teilweise luftschalldurchlässigen Dekorabdeckung DAK versehen.

Zur Erzeugung einer durchgehenden Abdeckung auf der Sichtinnenseite IS der in FIG 3 beispielhaft dargestellten Schirmungsmodule SM3, SM1 und SM2 kann in diesem Fall die zusätzliche Dekorabdeckung DAK vollständig um die Kanten des Abdeckkanals AK und des Schalldämmstreifens ST bis zur Dekorabdeckung DA auf den Schalldämmplatten SP herumgezogen sein.

Bei der schließlich in FIG 4 dargestellten Ausführungsform der Erfindung wird die Abdeckung der Kontaktbereiche KB1 bzw. KB2 zwischen den beispielhaft dargestellten Schirmungsmodulen SM1, SM2 bzw. SM1, SM3 durch zusätzliche, auf der Innenseite der miteinander verbundenen Schirmungsmodule angebrachte Schalldämmplatten SPZ1 und SPZ2 bewirkt. Die zusätzlichen Schalldämmplatten sind dabei so überlappend angebracht, daß die Kontaktbereiche KB1 und KB2 vollständig abgedeckt werden. Die überlappende Abdeckung der Innenseiten IS der Schirmungsmodule SM1, SM2 und SM3 durch die zusätzlichen Schalldämmplatten SPZ1 und SPZ2 im Beispiel der FIG 4 ist dabei so gestaltet, daß die Stoßkante SK zwischen den beiden zusätzlichen Schalldämmplatten auf der Fläche einer darunterliegenden Schalldämmplatte SP eines der Schirmungsmodule zu liegen kommt. Hierdurch ist eine vollständig dichte, akustikbrückenfreie Schalldämmung zwischen der Innen- und Außenseite IS, AS der verbundenen Schirmungsmodule möglich. Auch hierbei ist es vorteilhaft, wenn die zusätzlichen Schalldämmplatten SPZ1, SPZ2 über eine Klebeverbindung mit den darunterliegenden Schalldämmplatten DA verbunden werden. Da die Schalldammplatten in der Regel hochkomprimiert sind, ist es z.B. auch möglich, die zusätzlichen Schalldämmplatten durch Schraub- oder Dübelelemente zu befestigen, welche in die darunterliegenden Schalldämmplatten SP eingreifen. In jedem Fall können die zusätzlichen Schalldämmplatten so angebracht werden, daß hierdurch die elektromagnetische Abschirmwirkung der miteinander kontaktierten Schirmbleche SB1, SB2, SB3 in keiner Weise beeinträchtigt wird. Schließlich können die Sichtinnenseiten der zusätzlichen Schalldämmplatten ebenfalls mit zusätzlichen, bevorzugt zumindest teilweise luftschalldurchlässigen Dekorabdeckungen DAZ versehen werden. In diesem Fall können die Dekorabdeckungen DA auf der Innenseite der darunterliegenden Schalldämmplatten SP entfallen. Falls diese Dekorabdeckung DA jedoch mit der dazugehörigen Schalldämmplatte SP einen Verbundbaukörper bilden, so stellen diese eine gute Tragoberfläche zum Anbringen der zusätzlichen Schalldämmplatten SPZ1, SPZ2 dar.

**Patentansprüche**

1. Selbsttragendes Schirmungsmodul (SM1,SM2,SM3) zum modularen Aufbau von freistehenden Kabinen, Räumen oder Hallen bzw. von inneren Auskleidungen, Abdeckungen oder Abtrennungen für Räume, Hallen oder Gebäude, welches zur Abschirmung gegen den Einfall bzw. die Abstrahlung von elektromagnetischer Strahlung dient, mit
   a) einem einteiligen, wannenförmigen Schirmblech (SB1,SB2,SB3) mit aufgekanteten Seitenstreifen, welche als Kontaktbereiche (KB1,KB2) für die direkte mechanische und elektrisch leitende Verbindung zu benachbarten Schirmungsmodulen dienen, und mit
   b) mindestens einer selbsttragenden Schalldämmplatte (SP), welche möglichst hohlraumfrei auf der Innenseite des wannenförmigen Schirmbleches (SB1, SB2, SB3) aufgeklebt ist.

2. Vorrichtung nach Anspruch 1, **dadurch gekennzeichnet,** daß zusätzlich Schraub- und/oder Nietverbindungen zur weiteren Sicherungshalterung der mindestens einen Schalldämmplatte vorhanden sind.

3. Vorrichtung nach Anspruch 1 oder 2, **dadurch gekennzeichnet** durch eine zumindest teilweise luftschalldurchlässige Dekorabdeckung (DA) auf der Sichtinnenseite (SS,IS) der Schalldämmplatte (SP), insbesondere ein Lochblech bzw. eine Lochblechwanne.

4. Vorrichtung nach Anspruch 3, **dadurch gekennzeichnet,** daß Schalldämmplatte (SP) und Dekorabdeckung (DA) einen Verbundbaukörper bilden.

5. Vorrichtung nach einem der vorangegangenen Ansprüche, **dadurch gekennzeichnet,** daß die Kontaktbereiche (KB1,KB2) des Schirmungsmodules bildenden, wannenförmig aufgekanteten Ränder des Schirmbleches (SB1,SB2,SB3) nicht von der Schalldämmplatte (SP) ausgefüllt sind.

6. Vorrichtung nach Anspruch 5, **dadurch gekennzeichnet,** daß der Kontaktbereich (KB1 bzw. KB2) zwischen den Schirmblechen (SB1,SB2,SB3) von zwei miteinander verbundenen Schirmungsmodulen (SB1,SB2 bzw. SB2,SB3) durch leistenförmige Abdeckmittel (AL bzw. AK) verschlossen ist, wobei die Abdeckmittel entweder flächenbündig auf den Sichtinnenseiten (IS,SS) der Schalldämmplatten (SP) der benachbarten Schirmungsmodule aufliegen (FIG 1, AL) oder kanalförmig aufgesetzt sind. (FIG 2, AK).

7. Vorrichtung nach Anspruch 6, **dadurch gekennzeichnet,** daß die Abdeckmittel (AL,AK) als Träger für Einbauelemente (EL,KK,K) dienen, z.B. für Schalter, Steckdosen, Kabelkanäle.

8. Vorrichtung nach Anspruch 6 oder 7, **dadurch gekennzeichnet,** daß die Abdeckmittel (AL,AK) zusätzlich durch Schalldämmstreifen (ST) abgedeckt sind (FIG 3).

9. Vorrichtung nach Anspruch 8, **dadurch gekennzeichnet,** daß die Schalldämmstreifen (ST) mit einer zumindest teilweise luftschalldurchlässigen Dekorabdeckung (DAK) versehen sind (FIG 3).

10. Vorrichtung nach einem der Ansprüche 1 bis 5, **dadurch gekennzeichnet,** daß auf der Innenseite (IS) von zumindest zwei miteinander verbundenen Schirmungsmodulen (SB1, SB2 bzw. SB2,SB3) zumindest eine zusätzliche Schalldämmplatte (SPZ1 bzw. SPZ2) so überlappend angebracht ist, daß die Kontaktbereiche (KB1 bzw. KB2) zwischen den Schirmungsmodulen vollständig abgedeckt sind und mögliche Stoßkanten (SK) zwischen zusätzlichen Schalldämmplatten sich auf der Fläche einer darunter liegenden Schalldämmplatte (SP) eines der Schirmungsmodule befinden (FIG 4).

FIG 1

FIG 2

FIG 3

FIG 4